(19) Europäisches Patentamt

European Patent Office

Office européen des brevets

(11) **EP 1 426 977 A1**

(12) **EUROPEAN PATENT APPLICATION**

(43) Date of publication:
**09.06.2004 Bulletin 2004/24**

(51) Int Cl.7: **G21K 4/00**

(21) Application number: **02102491.4**

(22) Date of filing: **25.10.2002**

| | |
|---|---|
| (84) Designated Contracting States: **AT BE BG CH CY CZ DE DK EE ES FI FR GB GR IE IT LI LU MC NL PT SE SK TR** Designated Extension States: **AL LT LV MK RO SI** (71) Applicant: **AGFA-GEVAERT 2640 Mortsel (BE)** | (72) Inventors: • **Leblans, Paul B-2640 Mortsel (BE)** • **Struye, Luc B-2640 Mortsel (BE)** |

(54) **Storage phosphor screen and preparation method**

(57) A method of preparing a phosphor screen having at least a substrate and a phosphor layer comprising a CsX:Eu$^{2+}$ phosphor wherein X represents a halide selected from a group consisting of Br and Cl and wherein the phosphor is deposited by physical vapour deposition on the substrate. During deposition the substrate is at a temperature in the range of 135°C to 235°C and variation of the temperature of the substrate occurring during the deposition process is not more than 50°C.

FIG. 1

Printed by Jouve, 75001 PARIS (FR)

**Description**

FIELD OF THE INVENTION

The present invention relates to a method of producing a storage phosphor screen by physical vapour deposition of a phosphor layer on a substrate.

BACKGROUND OF THE INVENTION

In radiography it is important to have excellent image quality for the radiologist to make an accurate evaluation of a patient's condition. It is evident that image quality must be substantially constant over the complete image area.
Important image quality aspects are image resolution and image signal-to-noise ratio. For a reliable imaging system, resolution and signal-to-noise ratio do not vary significantly over the area of the image.
In computed radiography storage phosphor screens are nowadays widely used as an intermediary storage medium. For example in European patent application 1 203 394 a specific phosphor for such use has been described.
For this type of radiography signal-to-noise ratio depends on a number of factors.
First, the number of X-ray quanta absorbed by the storage phosphor screen is important. The signal-to-noise ratio is proportional to the square-root of the number of absorbed quanta.
Secondly, the so-called fluorescence noise is important. This noise is caused by the fact that the number of photostimulated light (PSL) quanta detected per absorbed X-ray quantum is small. Since a lot of the PSL light is lost in the detection process in computed radiography, fluorescence noise has an important contribution to the signal-to-noise ratio. It is important that, on the average, at least 1 photon is detected for every absorbed X-ray quantum. If this is not the case, many absorbed X-ray quanta will not contribute to the image and signal-to-noise ratio will be very poor.
This situation is most critical in mammography, where X-ray quanta are used with low energy. Softer X-rays will give rise to less PSL centres and, therefore, to less PSL photons than harder X-rays.
In computed radiography, a number of PSL centres are created by the absorbed X-ray quanta. Not all PSL centres are stimulated in the read-out process, because of the limited time available for pixel stimulation and because of the limited laser power available. In practice, only about 30% of the PSL centres is stimulated to give rise to a PSL photon. Since these photons are emitted and scattered in all directions, only 50% of the PSL photons are emitted at the top side of the storage phosphor screen, where they can be detected by the detection system. The emitted PSL photons are guided towards the detector by a light guide. This light guide may consists of a bundle of optical fibres having a rectangular detection area above the storage phosphor screen and a circular cross-section at the detector side. This type of light guide has a numerical aperture of only 30%, which means that only 1 out of 3 of the emitted PSL photons is guided to the detector. In between the light guide and the detector a filter is placed, which stops the stimulation light reflected by the storage phosphor screen and transmits the PSL light emitted by the screen. This filter also has a small absorption and reflection of PSL light and transmits only ca. 75% of the PSL photons. In computed radiography a photomultiplier is commonly used to transform the PSL signal into an electrical signal. At 440 nm the photomultiplier has a quantum efficiency of ca. 20%. This means that only 1 out of 5 PSL quanta that reach the photomultiplier are detected.
In summary, for 1,000 PSL centres that are created in the storage phosphor screen only:

$$1,000 \times 0.3 \times 0.5 \times 0.3 \times 0.75 \times 0.2 = 6.75$$

PSL photons are detected.
If it is needed that every X-ray quantum gives rise to at least 1 detected PSL photon, the number of PSL centres created by an X-ray quantum should be sufficiently large. Or, conversely, the X-ray energy needed to create a PSL-centre should be sufficiently small.
In mammography, a usual setting of the X-ray source is at 28 kVp. This leads to an X-ray spectrum, where the average energy of an X-ray quantum is of the order of 15 keV. For an X-ray quantum with this energy to give rise to at least 1 detected PSL photon, the energy needed to create a PSL centre should be less than:

$$15,000 \times 6.75 / 1,000 = 100 \text{ eV}.$$

It is an aspect of the present invention to provide a method of manufacturing a photostimulable phosphor screen for use in a computed radiography system that allows to make images with good signal-to-noise ratio, even when using X-ray quanta having low energy as is the case in mammographic imaging.

Further objects will become apparent from the description below.

SUMMARY OF THE INVENTION

The objects of the present invention are achieved by a method of manufacturing a storage phosphor as set out in claim 1.

The phosphor obtained by the method of the present invention has a high conversion efficiency. A low amount of X-ray energy, less than 100 eV over the complete phosphor area is needed to create a PSL center.

The X-ray energy needed to create a PSL centre is thus low over the complete phosphor screen area in order to have a constant, high SNR over the complete image area.

Further aspects of the present invention will become clear from the detailed description given below and from the accompanying drawing.

BRIEF DESCRIPTION OF THE DRAWINGS

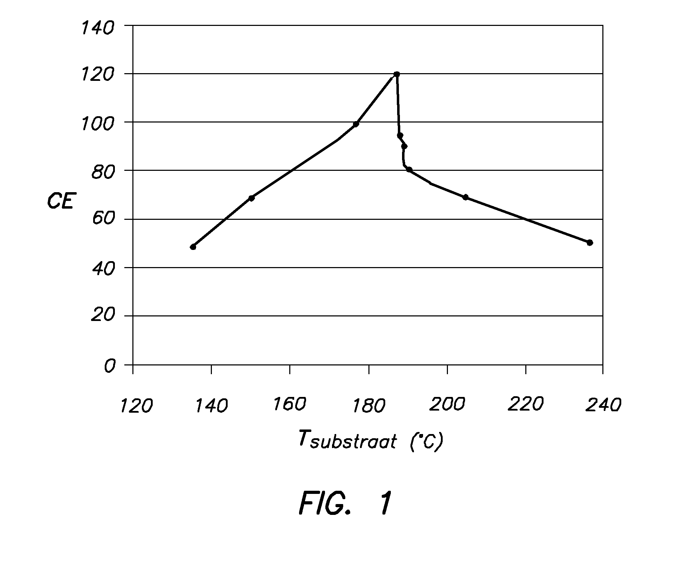

Figure 1 is a plot of the conversion efficiency as a function of the substrate temperature during vapour deposition of CsBr and EuOBr.

DETAILED DESCRIPTION OF THE INVENTION

CsBr:Eu$^{2+}$ screens according to the present invention were prepared via thermal vapour deposition of CsBr and EuOBr.

To this aim, CsBr was mixed with EuOBr and placed in a container in a vacuum deposition chamber.

The phosphor was deposited on a glass disk with a thickness of 1.5 mm and a diameter of 40 mm. The distance between the container and the substrate was 10 cm. During vapour deposition, the substrate was rotated at 12 rpm.

Before the start of the evaporation, the chamber was evacuated to a pressure of $4.10^{-5}$ mbar. During the evaporation process, Ar was introduced in the chamber.

Before starting the deposition, the substrate was heated to an initial temperature via heat radiation transfer from an electrically heated metal plate.

Upon starting the deposition, the temperature rose to a higher value because the condensation heat of the deposited material was transferred to the substrate.

During further deposition at constant deposition rate, the temperature remained constant.

Different screens were produced having the substrate at different temperatures as indicated in table 1 below.

Table 1

| Sample | Thickness (μ) | $T_{substrate}$ (°C) | C.E.2 pJ/mm$^2$/mR | number photons emitted | X-ray energy for 1 PSL centre (eV) |
|---|---|---|---|---|---|
| Compar. 1 | 550 | 135 | 49 | $1.09\ 10^8$ | 124 |
| Example 2 | 326 | 150 | 69 | $1.54\ 10^8$ | 88 |
| Example 3 | 370 | 176 | 99 | $2.21\ 10^8$ | 61 |
| Example 4 | 644 | 187 | 120 | $2.68\ 10^8$ | 50 |
| Example 5 | 514 | 188 | 95 | $2.12\ 10^8$ | 64 |
| Example 6 | 566 | 189 | 91 | $2.03\ 10^8$ | 67 |
| Example 7 | 393 | 190 | 81 | $1.81\ 10^8$ | 75 |
| Example 8 | 654 | 205 | 70 | $1.56\ 10^8$ | 87 |
| Compar. 9 | 695 | 237 | 51 | $1.14\ 10^8$ | 118 |

The indicated temperature is the temperature that is reached during deposition under constant transfer of condensation heat.

These results are plotted in figure 1.

The total photostimulable energy stored upon exposure to a given X-ray dose was determined. This property is expressed as "conversion efficiency" (C.E.).

The conversion efficiency was measured as follows.

Prior to X-ray excitation any residual energy still present in the phosphor screen was removed by irradiation of the screen with light of a 500 W quartz-halogen lamp.

The phosphor screen was then excited with an X-ray source operating at 80 kVp and 5 mA. For that purpose the BALTEAUGRAPHE 2000 (tradename) X-ray source of Balteau, France was used. The low energy X-rays were filtered out with a 21 mm thick aluminum plate to harden the X-ray spectrum.

After X-ray excitation the phosphor screen was transferred in the dark to the measurement set-up. In this set-up laser light was used to photostimulate the X-ray irradiated phosphor screen. The laser used in this measurement was a diode laser emitting at 690 nm with a power of 5 mW. The diode laser was the type LT030-MD, trade name of Sharp, USA.

The laser-optics comprised an electronic shutter, a beam-expander and a filter. A photomultiplier (HAMAMATSU R 376) collected the light emitted by the photostimulation and gave a corresponding electrical current. The measurement procedure was controlled by a Hewlett Packard HP 382 (tradename) computer connected to a HP 6944 (tradename) multiprogrammer.

After amplification with a current to voltage converter a TEKTRONIX TDS 420 (tradename) digital oscilloscope visualised the photocurrent obtained.

When the electronic shutter was opened the laser beam began to stimulate the phosphor screen and the digital oscilloscope was triggered. Using a diaphragm placed in contact with the screen the light emitted by only 7 mm$^2$ was collected. Approximately half of the laser power (2 mW) reached the screen surface. In this way the intensity of the stimulating beam was more uniform.

The stimulating laser light (transmitted by the crystal) and the stimulated emission light were separated by a 6 mm BG 39 SCHOTT (trade name) filter, so that only the emitted light reached the photomultiplier.

The signal amplitude from the photomultiplier is linear with the intensity of the photostimulating light and with the stored photostimulable energy. The signal decreases with time. When the signal curve was entered the oscilloscope was triggered a second time to measure the offset which was defined as the component of error that was constant and independent of inputs. After subtracting this offset the point at which the signal reaches 1/e of the maximum value was calculated. The integral below the curve was then calculated from the start to this 1/e point. The function was described mathematically by $f(t) = A.e^{-t/\tau}$ ; wherein A is the amplitude, $\tau$ is the time constant, t is stimulation time, and e is the base number of natural logarithms.

The 1/e point is reached when $t = \tau$ at which 63 % of the stored energy has been released. To obtain this result, the computer multiplies the integral with the sensitivity of the system. The sensitivity of the photomultiplier and amplifier have therefore to be measured as a function of anode-cathode voltage of the photomultiplier and the convolution of the emission spectrum of the phosphor, the transmission spectrum of the 6 mm BG 39 SCHOTT (trade name) filter and the wavelength dependence of the response of the photomultiplier have to be calculated.

Because the emission light was scattered in all directions only a fraction of the emitted light was detected by the photomultiplier. The position of the panel and photomultiplier were such that 10 % of the total emission was detected by the photomultiplier. The measuring result was corrected for this by multiplying it by 10.

The different screens had different thickness and, therefore, different X-ray absorption. In order to correct for this, the absorption was calculated, based on the shape of the X-ray spectrum at 80 kVp with 21 mm of Al filtering, on the attenuation coefficient of CsBr as a function of X-ray energy and on the thickness of every individual screen. For each screen, the measuring result was divided by the figure representing the fraction of X-ray energy absorbed by the screen.

After all these corrections, the conversion efficiency was obtained in pJ/mm$^2$/mR giving the amount of light energy that was obtained upon complete stimulation of 1 mm$^2$ of the storage phosphor screen after absorption of 1 mR of X-ray energy (Table 1).

The X-ray energy needed to create 1 PSL centre was calculated as follows.

At 80 kVp and 21 mm Al filtering, the average X-ray energy is 50 keV and 1 mR corresponds to 270,000 X-ray quanta per mm$^2$. Hence, an absorbed X-ray dose of 1 mR corresponds to an absorbed amount of energy of 1.35 10$^{10}$ eV.

The number of photons emitted upon complete stimulation after absorption of 1.35 10$^{10}$ eV is the conversion efficiency, divided by the photon energy, which is 2.8 eV at 440 nm.

The conversion efficiency multiplied by 6.242 10$^6$ for transformation of pJ in eV and divided by 2.8 gives the number of photons emitted (Table 1). The absorbed energy (1.35 10$^{10}$ eV) divided by this number leads to the energy needed to create a photostimulable centre.

From figure 1 can be deduced that a high conversion efficiency is obtained when the substrate is at a temperature in the range of 135°C to 235°C during the deposition process and when variation of the temperature of the substrate occurring during said deposition process is not more than 50°C.

In a preferred embodiment the above described temperature variation is not more than 30°C. Still more preferably the temperature variation is not more than 20°C since the conversion efficiency is very good in this case.

An even better result is obtained when the substrate is at a temperature in the range of 150°C to 220°C during the deposition process and when variation of the temperature of the substrate occurring during said deposition process is not more than 50°C.

The smaller the temperature variation the better the results.

Variations of not more than 30 %, preferably not more than 20% provide optimal results.

Most preferably the substrate is at a temperature in the range of 170°C to 200°C during the deposition process and variation of the temperature of the substrate occurring during said deposition process is not more than 20°C.

**Claims**

1. A method of preparing a phosphor screen having at least a substrate and a phosphor layer comprising a $CsX:Eu^{2+}$ phosphor wherein X represents a halide selected from a group consisting of Br and Cl, wherein said phosphor is deposited by physical vapour deposition on said substrate **characterised in that** during deposition said substrate is at a temperature in the range of 135°C to 235°C and wherein a variation of the temperature of the substrate occurring during said deposition process is not more than 50°C.

2. A method according to claim 1 wherein said variation of the temperature of the substrate is not more than 30°C.

3. A method according to claim 1 wherein said variation of the temperature of the substrate is not more than 20°C.

4. A method according to claim 1 wherein said phosphor layer is deposited at a temperature in the range of 150°C to 220°C.

5. A method according to claim 4 wherein said variation of the temperature of the substrate is not more than 30° C.

6. A method according to claim 4 wherein said variation of the temperature of the substrate is not more than 20° C.

7. A method according to claim 1 wherein said phosphor layer is deposited at a temperature in the range of 170°C - 200°C and wherein said variation of the temperature of the substrate is not more than 20° C.

8. A phosphor screen prepared according to any of claims 1-7.

FIG. 1

EP 1 426 977 A1

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | EP 1 113 458 A (AGFA GEVAERT) 4 July 2001 (2001-07-04) * paragraph [0016] * | 1,8 | G21K4/00 C09K11/465 |
| Y | PATENT ABSTRACTS OF JAPAN vol. 014, no. 021 (P-990), 17 January 1990 (1990-01-17) & JP 01 263600 A (KONICA CORP), 20 October 1989 (1989-10-20) * abstract * | 1,8 | |
| A | US 5 589 000 A (HARMS MICHAEL R ET AL) 31 December 1996 (1996-12-31) * abstract * | 1-8 | |
| A | PATENT ABSTRACTS OF JAPAN vol. 1998, no. 08, 30 June 1998 (1998-06-30) & JP 10 062599 A (KONICA CORP), 6 March 1998 (1998-03-06) * abstract * | 1-8 | |
| A | PATENT ABSTRACTS OF JAPAN vol. 014, no. 122 (P-1017), 7 March 1990 (1990-03-07) & JP 01 316699 A (KONICA CORP), 21 December 1989 (1989-12-21) * abstract * | 1-8 | TECHNICAL FIELDS SEARCHED (Int.Cl.7) G21K C09K |
| A | PATENT ABSTRACTS OF JAPAN vol. 016, no. 439 (P-1420), 14 September 1992 (1992-09-14) & JP 04 152300 A (KONICA CORP), 26 May 1992 (1992-05-26) * abstract * -/-- | 1-8 | |

The present search report has been drawn up for all claims

| Place of search | Date of completion of the search | Examiner |
|---|---|---|
| MUNICH | 7 March 2003 | Deroubaix, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

European Patent
Office

**EUROPEAN SEARCH REPORT**

Application Number

EP 02 10 2491

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | PATENT ABSTRACTS OF JAPAN<br>vol. 016, no. 439 (P-1420),<br>14 September 1992 (1992-09-14)<br>& JP 04 152299 A (KONICA CORP),<br>26 May 1992 (1992-05-26)<br>* abstract *<br>--- | 1-8 | |
| A | PATENT ABSTRACTS OF JAPAN<br>vol. 016, no. 439 (P-1420),<br>14 September 1992 (1992-09-14)<br>& JP 04 152298 A (KONICA CORP),<br>26 May 1992 (1992-05-26)<br>* abstract *<br>--- | 1-8 | |
| A | EP 0 327 134 A (FUJI PHOTO FILM CO LTD)<br>9 August 1989 (1989-08-09)<br>* page 7, line 37 - page 46 *<br>--- | 1-8 | |
| D,A | WO 01 03156 A (AGFA GEVAERT NV ;LEBLANS<br>PAUL (BE); STRUYE LUC (BE); REAVES CASPER)<br>11 January 2001 (2001-01-11)<br>* the whole document *<br>----- | 1-8 | TECHNICAL FIELDS<br>SEARCHED (Int.Cl.7) |

The present search report has been drawn up for all claims

| Place of search | Date of completion of the search | Examiner |
|---|---|---|
| MUNICH | 7 March 2003 | Deroubaix, P |

**EP 1 426 977 A1**

This annex lists the patent family members relating to the patent documents cited in the above-mentioned European search report.
The members are as contained in the European Patent Office EDP file on
The European Patent Office is in no way liable for these particulars which are merely given for the purpose of information.

07-03-2003

| Patent document cited in search report | | Publication date | Patent family member(s) | | Publication date |
|---|---|---|---|---|---|
| EP 1113458 | A | 04-07-2001 | EP | 1158540 A1 | 28-11-2001 |
| | | | EP | 1113458 A1 | 04-07-2001 |
| | | | JP | 2001249198 A | 14-09-2001 |
| | | | US | 2001007352 A1 | 12-07-2001 |
| JP 01263600 | A | 20-10-1989 | NONE | | |
| US 5589000 | A | 31-12-1996 | AU | 6724596 A | 27-03-1997 |
| | | | CA | 2230710 A1 | 13-03-1997 |
| | | | CN | 1195378 A | 07-10-1998 |
| | | | EP | 0848762 A1 | 24-06-1998 |
| | | | JP | 11512485 T | 26-10-1999 |
| | | | NO | 980918 A | 05-05-1998 |
| | | | WO | 9709462 A1 | 13-03-1997 |
| JP 10062599 | A | 06-03-1998 | NONE | | |
| JP 01316699 | A | 21-12-1989 | JP | 2829610 B2 | 25-11-1998 |
| JP 04152300 | A | 26-05-1992 | JP | 3070941 B2 | 31-07-2000 |
| JP 04152299 | A | 26-05-1992 | JP | 3070940 B2 | 31-07-2000 |
| JP 04152298 | A | 26-05-1992 | JP | 3070939 B2 | 31-07-2000 |
| EP 0327134 | A | 09-08-1989 | JP | 1201199 A | 14-08-1989 |
| | | | JP | 1960227 C | 10-08-1995 |
| | | | JP | 6097280 B | 30-11-1994 |
| | | | DE | 68918718 D1 | 17-11-1994 |
| | | | DE | 68918718 T2 | 16-02-1995 |
| | | | EP | 0327134 A2 | 09-08-1989 |
| | | | US | 4922105 A | 01-05-1990 |
| WO 0103156 | A | 11-01-2001 | AU | 5750800 A | 22-01-2001 |
| | | | EP | 1065523 A2 | 03-01-2001 |
| | | | EP | 1065524 A2 | 03-01-2001 |
| | | | EP | 1065525 A2 | 03-01-2001 |
| | | | EP | 1065526 A2 | 03-01-2001 |
| | | | EP | 1065527 A2 | 03-01-2001 |
| | | | EP | 1065528 A2 | 03-01-2001 |
| | | | EP | 1203394 A1 | 08-05-2002 |
| | | | JP | 2001075209 A | 23-03-2001 |
| | | | JP | 2001059897 A | 06-03-2001 |
| | | | JP | 2001074898 A | 23-03-2001 |
| | | | JP | 2001075210 A | 23-03-2001 |
| | | | JP | 2001074899 A | 23-03-2001 |

EPO FORM P0459

For more details about this annex : see Official Journal of the European Patent Office, No. 12/82

9

**EP 1 426 977 A1**

## ANNEX TO THE EUROPEAN SEARCH REPORT
## ON EUROPEAN PATENT APPLICATION NO.

EP 02 10 2491

07-03-2003

| Patent document cited in search report | Publication date | Patent family member(s) | Publication date |
|---|---|---|---|
| WO 0103156 A | | JP 2001074895 A | 23-03-2001 |
| | | JP 2003504458 T | 04-02-2003 |
| | | WO 0103156 A1 | 11-01-2001 |
| | | US 6501088 B1 | 31-12-2002 |
| | | US 6495850 B1 | 17-12-2002 |
| | | US 6504169 B1 | 07-01-2003 |
| | | US 6512240 B1 | 28-01-2003 |
| | | US 6479835 B1 | 12-11-2002 |